# EUROPEAN PATENT SPECIFICATION

(11) **EP 3 989 297 B1**
(45) Date of publication and mention of the grant of the patent: **24.04.2024**
(21) Application number: 20854978.2
(22) Date of filing: 20.08.2020
(51) Int. Cl.: H01L 33/06, H01L 33/14, H01L 33/32, H01L 33/00

(54) **DEEP-ULTRAVIOLET LED HAVING THICKNESS CHIRPED SUPERLATTICE FINAL BARRIER STRUCTURE AND PREPARATION METHOD**
TIEF-ULTRAVIOLETTE LED MIT DICKE-GECHIRPTER ÜBERGITTERENDBARRIERESTRUKTUR UND HERSTELLUNGSVERFAHREN
DEL À ULTRAVIOLET PROFOND AYANT UNE STRUCTURE DE BARRIÈRE FINALE À SUPER-RÉSEAU ET À L'ÉPAISSEUR CHIRPÉE ET PROCÉDÉ DE PRÉPARATION

(30) Priority: 21.08.2019 CN 201910775500
(43) Date of publication of application: 27.04.2022
(73) Proprietor: Suzhou Uvcantek Co., Ltd, Suzhou, Jiangsu 215000 (CN)
(72) Inventor: ZHANG, Jun, Suzhou, Jiangsu 215000 (CN); YUE, JinShun, Suzhou, Jiangsu 215000 (CN); LIANG, RenLi, Suzhou, Jiangsu 215000 (CN)
(74) Representative: Chung, Hoi Kan
(86) International application number: PCT/CN2020/110138
(87) International publication number: WO 2021/032142

(56) References cited:
- CN-A- 104 868 025
- CN-A- 106 537 617
- CN-A- 108 231 965
- CN-A- 110 600 591
- US-A1- 2010 219 395
- US-A1- 2011 168 977
- US-A1- 2013 069 034
- US-A1- 2019 006 821
- MONDAL RAMIT KUMAR ET AL: "Effect of step-graded superlattice electron blocking layer on performance of AlGaN based deep-UV light emitting diodes", PHYSICA E: LOW-DIMENSIONAL SYSTEMS AND NANOSTRUCTURES, vol. 108, 1 April 2019 (2019-04-01), pages 233-237, XP055782627, NL ISSN: 1386-9477, DOI: 10.1016/j.physe.2018.11.022
- Mondal Ramit Kumar, Chatterjee Vijay, Pal Suchandan: "Effect of step-graded superlattice electron blocking layer on performance of AlGaN based deep-UV light emitting diodes", Physica E: Low-dimensional Systems and Nanostructures, ELSEVIER SCIENCE BV, NL, vol. 108, 1 April 2019 (2019-04-01), pages 233-237, XP055782627, NL ISSN: 1386-9477, DOI: 10.1016/j.physe.2018.11.022
- Hideki Hirayama, Sachie Fujikawa, Norihiko Kamata: "Recent Progress in AlGaN-Based Deep-UV LEDs", ELECTRONICS AND COMMUNICATIONS IN JAPAN., Wiley-Blackwell Publishing, Inc., US, vol. 98, no. 5, 1 May 2015 (2015-05-01), pages 1-8, XP055249111, US ISSN: 1942-9533, DOI: 10.1002/ecj.11667

## Description

### Technical Field

The disclosure relates to deep ultraviolet LED with chirped superlattice final barrier structure and preparation method thereof.

### Background of the Invention

Group III nitrides, as an outstanding representative of wide-bandgap semiconductor materials, have realized high-efficiency blue-green light-emitting diodes (full name light-emitting diodes, LED for short), lasers and other solid-state light source devices. It has achieved great success in flat panel display, white light lighting and other applications. In the past ten years, people expect to apply this efficient luminescent material to the ultraviolet band to meet the growing demand for ultraviolet light sources. According to its biological effects, the ultraviolet band can usually be divided into: long-wave ultraviolet (UVA for short, wavelength is 320 ~ 400 nm), medium-wave ultraviolet (UVB for short, wavelength is 280 ~ 320 nm), short-wave ultraviolet (UVC for short, wavelength is 200 ~ 280 nm) and vacuum ultraviolet (VUV for short, the wavelength is 10 - 200 nm). Although ultraviolet light cannot be perceived by human eyes, its application is very wide. Long-wave ultraviolet light sources have great application prospects in medical treatment, ultraviolet curing, ultraviolet lithography, information storage, plant lighting and other fields. Deep ultraviolet light, including medium-wave ultraviolet and short-wave ultraviolet, plays an irreplaceable role in sterilization, water purification, biochemical detection, and non-line-of-sight communication. At present, traditional ultraviolet light sources are mainly mercury lamps, which have disadvantages such as large volume, high power consumption, high voltage, and environmental pollution, which are not conducive to its application in daily life and special environments. Therefore, people are eager to develop an efficient semiconductor ultraviolet light source device to replace the traditional mercury lamp. Existing research shows that AlGaN in group III nitrides is the best candidate material for the preparation of semiconductor UV light source devices. AIGaN-based UV-LEDs have many advantages such as being environmentally friendly, small and portable, low power consumption, low voltage, easy integration, long life, and adjustable wavelength. It is expected to achieve breakthrough progress and wide application in the next few years, and gradually replace traditional UV mercury lamp.

At present, the band gap of AlₓGa₁₋ₓN materials can be continuously adjusted from 3.4 eV (GaN) to 6.2 eV (AIN) by changing the Al composition, and can achieve light emission in the spectral range from 365nm to 200nm. Among them, the band-edge emission wavelength of GaN is about 360 nm, which is usually used as a division mark of the emission band of nitride ultraviolet light-emitting diodes (full name ultraviolet light-emitting diodes, UV-LED for short). The active area of UV-LEDs with emission wavelengths greater than 360 nm adopts a GaN / InGaN quantum well structure similar to that of the blue LED. The related research has started as early as the 1990s and has been successfully commercialized. The external quantum efficiency has also exceeded 40%, reaching a level comparable to blue LEDs.

Document "Effect of step-graded superlattice electron blocking layer on performance of AlGaN based deep-UV light emitting diodes" (R. K. Mondal et al., in Physica E: Low-dimensional Systems and Nanostructures, Vol. 108 (2019), p233-237) discloses a design modification in the deep-ultraviolet LEDs to emit wavelength of ~225 nm.

Patent document CN 108 231 965 A discloses an AlGaN based deep-UV LED epitaxial structure with a function of improving light output.

Patent document US 2013/0069034 A1 discloses that an Al0.95Ga0.05N:Mg (25 nm) single electron barrier can stop electrons having energy levels lower than the barrier height and that a 5-layer Al0.95Ga0.05N (4 nm)/Al0.77Ga0.23N (2 nm) MQB has quantum-mechanical effects so as to stop electrons having energy levels higher than the barrier height.

Patent document US 2011/0168977 A1 discloses an optoelectronic component including a semiconductor layer structure, the semiconductor layer structure including a superlattice composed of stacked layers of III-V compound semiconductors of a first and at least one second type.

In contrast, UV-LEDs with emission wavelengths less than 360 nm mainly use AlGaN quantum well structures as active regions, and their quantum efficiency is not good. One of the main reasons for the low efficiency of high Al composition AlGaN based deep ultraviolet LEDs is the obvious electron overflow effect. The electrons from the electron injection layer cross the electron blocking layer to the p-type layer, causing the p-type layer to emit light and reduce the internal quantum efficiency. Therefore, it is necessary to propose a new ultraviolet LED solution to solve the problems existing in the prior art.

### Summary of the Invention

The invention is set out in the appended set of claims.

The purpose of the present invention is to provide a deep ultraviolet LED with chirped superlattice final barrier structure and preparation method thereof for solving the problems of low efficiency of deep ultraviolet LEDs due to the electronic overflow effect in the prior art.

The deep ultraviolet LED with chirped superlattice final barrier structure comprises a sapphire substrate, an AIN intrinsic layer, an N-type AlGaN layer, a current spreading layer, a quantum well active layer, a chirped superlattice final barrier layer, an electron blocking layer, a P-type AlGaN injection layer and a P-type GaN contact layer.

The AIN intrinsic layer, the N-type AlGaN layer, the current spreading layer, the quantum well active layer, the chirped superlattice final barrier layer, the electron blocking layer, the P-type AlGaN injection layer and the P-type GaN contact layer are sequentially deposited on the sapphire substrate. In accordance with the invention, the chirped superlattice final barrier layer is a superlattice structure that is chirped in thickness and is composed of several AlₐGa₁₋ₐN layers and several Al_{b}Ga_{1-b}N layers alternately disposed.

The preparation method of deep ultraviolet LED with chirped superlattice final barrier structure includes the following steps:
At 400 - 800 °C, growing a buffer layer on a sapphire substrate and the thickness of the buffer layer is 10 - 50 nm.

Raising the temperature to 1200 ~ 1400 °C, and an AIN intrinsic layer is grown on the buffer layer, the total thickness of the AIN intrinsic layer is 500 - 4000 nm.

Cooling to 800 - 1200 °C, and an N-type AlGaN layer is grown on the AIN intrinsic layer, wherein the Al mass percentage is 20 - 90 %, and the thickness is 500 - 4000 nm.

Cooling to 700 - 1100 °C, and a current spreading layer and a quantum well active layer are sequentially grown on the N-type AlGaN layer, wherein the thickness of the barrier in the quantum well active layer is 5 ~30 nm and the mass percentage of Al composition in the barrier is 20 - 100 %; the thickness of the potential well is 0.1 - 5 nm and the mass percentage of Al composition in the potential well is 5 - 80 %.

At 700 - 1100 °C, growing a chirped superlattice final barrier layer on the quantum well active layer; the chirped superlattice final barrier layer is a superlattice structure that is chirped in thickness and is composed of several AlₐGa₁₋ₐN layers and several Al_{b}Ga_{1-b}N layers alternately, and a<b, wherein the thickness of the Al_{b}Ga_{1-b}N layer is 0.1 - 5 nm and 0.2<b<1, and the thickness of the AlₐGa₁₋ₐN layer is 0.1 - 5 nm and 0.05 < a < 0.8.

At 700 - 1100 °C, growing an electron blocking layer on the chirped superlattice final barrier layer with a thickness of 5 - 50 nm and 30 - 100 mass % of Al.

At 700 - 1100 °C, growing a P-type AlGaN injection layer on the electron blocking layer with 5 - 100 mass % of Al and a thickness of 1 - 50 nm, and Mg is used as the P-type dopant.

At 400 - 900 °C, a P-type GaN contact layer is grown on the P-type AlGaN injection layer with a thickness of 1 - 20 nm, and Mg is used as the P-type dopant.

The beneficial effect of the technical scheme proposed in the present invention is: by introducing the chirped superlattice final barrier layer, the present invention reduces the probability of electron tunneling to the P-type AlGaN injection layer, and reduces the electron overflow effect, thereby improving the luminous efficiency of the deep ultraviolet LED.

### Brief description of the Drawings

Accompanying drawings are for providing further understanding of embodiments of the invention. The drawings form a part of the disclosure and are for illustrating the principle of the embodiments of the invention along with the literal description. Apparently, the drawings in the description below are merely some embodiments of the invention, a person skilled in the art can obtain other drawings according to these drawings without creative efforts. In the figures:
FIG. 1 is a schematic diagram of a deep ultraviolet LED with chirped superlattice final barrier structure;
FIG. 2 is an energy band diagram of a deep ultraviolet LED with chirped superlattice final barrier structure;
FIG. 3 is an optical power graph of a deep ultraviolet LED with chirped superlattice final barrier structure.

### Detailed Description of Embodiments

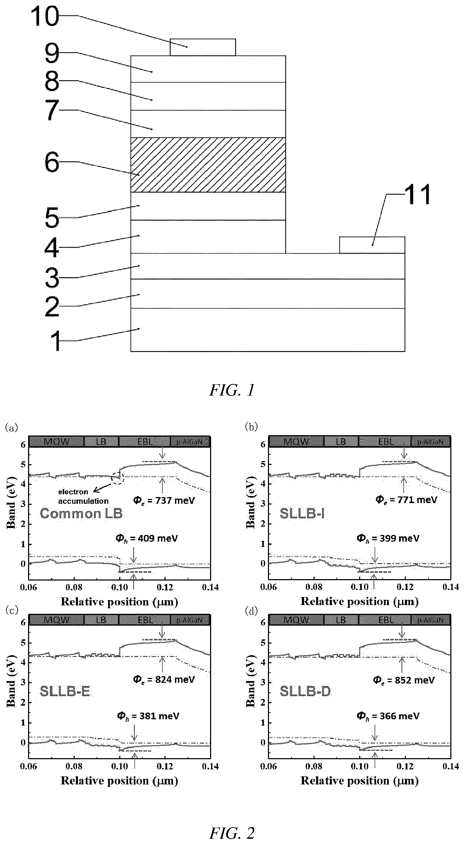

For the first solution provided by the present invention, refer to FIG 1, it is provided a deep ultraviolet LED with chirped superlattice final barrier structure, which is characterized by comprising a sapphire substrate (1), an AIN intrinsic layer (2), an N-type AlGaN layer (3), a current spreading layer (4), a quantum well active layer (5), a chirped superlattice final barrier layer (6), an electron blocking layer (7), P-type AlGaN injection layer (8) and P-type GaN contact layer (9); depositing the AIN intrinsic layer (2), N-type AlGaN layer (3), current spreading layer (4), quantum well active layer (5), chirped superlattice final barrier layer (6), electron blocking layer (7), P-type AlGaN injection layer (8) and P-type GaN contact layer (9) sequentially on the sapphire substrate (1); in addition, a P-type electrode (10) can be arranged on the P-type GaN contact layer (9), and an N-type electrode (11) can be arranged on the side of the N-type AlGaN layer (3) away from the current spreading layer (4), to form a complete deep ultraviolet LED device; the final barrier layer of the chirped superlattice (6) is a superlattice structure that is, in accordance with the invention, chirped in thickness and is composed of several AlₐGa₁₋ₐN layers and several Al_{b}Ga_{1-b}N layers alternately. By introducing the chirped superlattice final barrier layer, the present invention reduces the probability of electron tunneling to the P-type AlGaN injection layer, and reduces the electron overflow effect, thereby improving the luminous efficiency of the deep ultraviolet LED.

Specifically, the structure setting of the chirped superlattice final barrier layer is described in detail. The chirped superlattice final barrier layer includes n periods of the AlₐGa₁₋ₐN layer and the Al_{b}Ga_{1-b}N layer, and n≥2; in the period of nᵢ=1, the thickness of the AlₐGa₁₋ₐN layer and the Al_{b}Ga_{1-b}N layer are x and y respectively; in the direction from the quantum well active layer to the electron blocking layer, and in the n periods of the AlₐGa₁₋ₐN layer and the Al_{b}Ga_{1-b}N layer, the thickness of the AlₐGa₁₋ₐN layer and the Al_{b}Ga_{1-b}N layer are x ± (nᵢ-1)*t and y ± (nᵢ-1)*t respectively, and 0.1 nm≤t≤10 nm, whereby nᵢ runs from 1 to n. In this scheme, the thickness of the multi-period AlₐGa₁₋ₐN layer and the Al_{b}Ga_{1-b}N layer can either be a synchronous linear increase method or a synchronous linear decrease method. These two setting methods can be selected according to the actual situation and not limited here.

For the setting of the composition ratio of the chirped superlattice final barrier layer, there can be the following four setting methods: (1) the AlₐGa₁₋ₐN layer is a single layer structure of a single AlₐGa₁₋ₐN composition, and the Al_{b}Ga_{1-b}N layer is a single layer structure of a single Al_{b}Ga_{1-b}N composition, wherein 0.4<a<b<1 ; (2) the AlₐGa₁₋ₐN layer has a single layer structure with graded composition, and the Al composition ratio a linearly grades from c to d; the Al_{b}Ga_{1-b}N layer is a single layer structure of a single Al_{b}Ga_{1-b}N composition, wherein 0.4 < c < d < b < 1; (3) the AlₐGa₁₋ₐN layer is a single layer structure of a single AlₐGa₁₋ₐN composition; the Al_{b}Ga_{1-b}N layer has a single layer structure with graded composition, and the Al composition ratio b linearly grades from e to f, wherein 0.4 < a < f < e < 1; (4) the AlₐGa₁₋ₐN layer has a single layer structure with graded composition, and the Al composition ratio a linearly grades from g to h; the Al_{b}Ga_{1-b}N layer has a single layer structure with graded composition, and the Al composition ratio b linearly grades from j to k, wherein 0.4<g<h<j<k<1.

Based on the setting of the thickness and composition ratio of the chirped superlattice final barrier layer, it can be seen that there are always eight specific setting methods for the chirped superlattice final barrier layer in this scheme, which are as follows: (1) the thickness of the AlₐGa₁₋ₐN layer and the Al_{b}Ga_{1-b}N layer in the multi-period increase sequentially, and the AlₐGa₁₋ₐN layer is a single layer structure of a single AlₐGa₁₋ₐN composition, and the Al_{b}Ga_{1-b}N layer is a single layer structure of a single Al_{b}Ga_{1-b}N composition; (2) the thickness of the AlₐGa₁₋ₐN layer and the Al_{b}Ga_{1-b}N layer in the multi-period increase sequentially, and the AlₐGa₁₋ₐN layer is a single layer structure with graded composition, and the Al_{b}Ga_{1-b}N layer is a single layer structure of a single Al_{b}Ga_{1-b}N composition; (3) the thickness of the AlₐGa₁₋ₐN layer and the Al_{b}Ga_{1-b}N layer in the multi-period increase sequentially, and the AlₐGa₁₋ₐN layer is a single layer structure of a single AlₐGa₁₋ₐN composition, and the Al_{b}Ga_{1-b}N layer is a single layer structure with graded composition; (4) the thickness of the AlₐGa₁₋ₐN layer and the Al_{b}Ga_{1-b}N layer in the multi-period increase sequentially, and the AlₐGa₁₋ₐN layer is a single layer structure with graded composition, and the Al_{b}Ga_{1-b}N layer is a single layer structure with graded composition; (5) the thickness of the AlₐGa₁₋ₐN layer and the Al_{b}Ga_{1-b}N layer in the multi-period decrease sequentially, and the AlₐGa₁₋ₐN layer is a single layer structure of a single AlₐGa₁₋ₐN composition, and the Al_{b}Ga_{1-b}N layer is a single layer structure of a single Al_{b}Ga_{1-b}N composition; (6) the thickness of the AlₐGa₁₋ₐN layer and the Al_{b}Ga_{1-b}N layer in the multi-period decrease sequentially, and the AlₐGa₁₋ₐN layer is a single layer structure with graded composition, and the Al_{b}Ga_{1-b}N layer is a single layer structure of a single Al_{b}Ga_{1-b}N composition; (7) the thickness of the AlₐGa₁₋ₐN layer and the Al_{b}Ga_{1-b}N layer in the multi-period decrease sequentially, and the AlₐGa₁₋ₐN layer is a single layer structure of a single AlₐGa₁₋ₐN composition, and the Al_{b}Ga_{1-b}N layer is a single layer structure with graded composition; (8) the thickness of the AlₐGa₁₋ₐN layer and the Al_{b}Ga_{1-b}N layer in the multi-period decrease sequentially, and the AlₐGa₁₋ₐN layer is a single layer structure with graded composition, and the Al_{b}Ga_{1-b}N layer is a single layer structure with graded composition. Appropriate setting schemes can be adopted according to actual needs, which are not limited here.

Please refer to FIG. 2. FIG. 2 is an energy band diagram of a deep ultraviolet LED with chirped superlattice final barrier structure in the present invention; wherein common LB in part a of FIG. 2 represents the energy band of the traditional final barrier structure, and SLLB-I, SLLB-E, and SLLB-D respectively represent three samples of the deep ultraviolet LED with the chirped superlattice final barrier structure in part b, c, d of FIG. 2. It can be seen from the comparison, the chirped superlattice final barrier structure can increase the electron barrier height of the electron blocking layer, and reduce the height of the hole injection barrier, thereby preventing electrons from transporting to p-type layers. This reduces the electron overflow effect.

For the second solution provided by the present invention, it is provided a preparation method of deep ultraviolet LED with chirped superlattice final barrier structure, including the following steps:
(1) At 400 ~ 800 °C, growing a buffer layer on a sapphire substrate and the thickness of the buffer layer is 10 - 50 nm.
(2) Raising to 1200 ~ 1400 °C, and an AIN intrinsic layer is grown on the buffer layer, the total thickness of the AIN intrinsic layer is 500 - 4000 nm.
(3) Cooling to 800 - 1200 °C, and an N-type AlGaN layer is grown on the AIN intrinsic layer, wherein the Al mass percentage is 20 - 90 %, and the thickness is 500 - 4000 nm.
(4) Cooling to 700 - 1100 °C, and a current spreading layer and a quantum well active layer are sequentially grown on the N-type AlGaN layer; the composition of the current spreading layer and the quantum well active layer are both AlGaN, but there are changes in the microstructure and composition ratio; for example, the quantum well active layer is an AlGaN film layer with a multiple quantum well structure that is composed of a quantum barrier and a quantum well alternately, in which the Al mass percentage of the quantum barrier is higher, and the Al mass percentage of the quantum well is relatively lower; the thickness of the barrier in the quantum well active layer 5 - 30 nm and the mass percentage of Al composition in the barrier is 20 - 100%, the thickness of the potential well is 0.1 - 5 nm and the mass percentage of Al composition in the potential well is 0 ∼ 80 %, preferably, the mass percentage of Al composition in the potential well is 5 ~ 80 %; the thickness of the current spreading layer is 20 - 200 nm, and the mass percentage of Al composition is 20 - 100 %.
(5) At 700 - 1100 °C, growing a chirped superlattice final barrier layer on the quantum well active layer; the chirped superlattice final barrier layer is a superlattice structure that is chirped in thickness and is composed of several AlₐGa₁₋ₐN layers and several Al_{b}Ga_{1-b}N layers alternately, and a<b, wherein the thickness of the Al_{b}Ga_{1-b}N layer is 0.1 - 5 nm and 0.2<b<1, and the thickness of the AlₐGa₁₋ₐN layer is 0.1 - 5 nm and 0 < a < 0.8, preferably, 0.05 < a < 0.8.
(6) At 700 - 1100 °C, growing an electron blocking layer on the chirped superlattice final barrier layer with a thickness of 5 - 50 nm and 30 - 100 mass % of Al.
(7) At 700 - 1100 °C, growing a P-type AlGaN injection layer on the electron blocking layer with 0 - 100 mass % of Al and a thickness of 1 - 50 nm, preferably, 5 - 100 mass % of Al, and Mg is used as the P-type dopant.
(8) At 400 ~ 900 °C, a P-type GaN contact layer is grown on the P-type AlGaN injection layer with a thickness of 1 ~ 20 nm, and Mg is used as the p-type dopant.

The preparation method of the deep ultraviolet LED with the chirped superlattice final barrier structure in the second solution is used to prepare the deep ultraviolet LED with the chirped superlattice final barrier structure in the first solution. Therefore, the structure and function of the deep ultraviolet LED with chirped superlattice final barrier structure in the two solutions should be consistent.

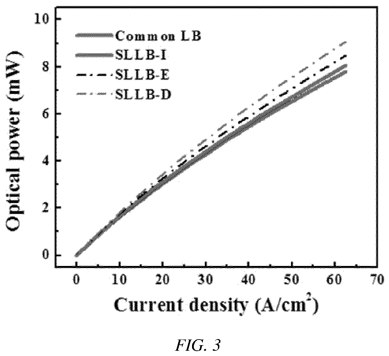

Further, the optical power of the above-mentioned deep ultraviolet LED with the chirped superlattice final barrier structure was tested, and compared with the deep ultraviolet LED with the traditional final barrier structure. The result is shown as shown in FIG. 3. According to FIG. 3, it is obtained that the optical power of the deep ultraviolet LED with the chirped superlattice final barrier structure in the present invention is 16.3 % higher than that of the traditional deep ultraviolet LED. It is proved that the deep ultraviolet LED with the chirped superlattice final barrier structure in the present invention can significantly improve the luminous efficiency of the device.

In summary, the present invention provides a deep ultraviolet LED with chirped superlattice final barrier structure and preparation method thereof. By introducing the chirped superlattice final barrier layer, the present invention reduces the probability of electron tunneling to the P-type AlGaN injection layer, and reduces the electron overflow effect, thereby improving the luminous efficiency of the deep ultraviolet LED.

It is to be understood, however, that even though numerous characteristics and advantages of the present invention have been set forth in the foregoing description, together with details of the composition and method of the invention, the disclosure is illustrative only, and changes may be made in detail to the extent defined by the appended claims.

## Claims

1. A deep ultraviolet LED with chirped superlattice final barrier structure, comprising a sapphire substrate (1), an AIN intrinsic layer (2), an N-type AlGaN layer (3), a current spreading layer (4), a quantum well active layer (5), a chirped superlattice final barrier layer (6), an electron blocking layer (7), a P-type AlGaN injection layer (8) and a P-type GaN contact layer (9); wherein the AIN intrinsic layer (2), the N-type AlGaN layer (3), the current spreading layer (4), the quantum well active layer (5), the chirped superlattice final barrier layer (6), the electron blocking layer (7), the P-type AlGaN injection layer (8) and the P-type GaN contact layer (9) have been sequentially deposited on the sapphire substrate (1);
the chirped superlattice final barrier layer (6) is a superlattice structure that is chirped in thickness and is composed of several AlₐGa₁₋ₐN layers and several Al_{b}Ga_{1-b}N layers alternately disposed;
wherein the chirped superlattice final barrier layer (6) is composed of n periods of the AlₐGa₁₋ₐN layer and the Al_{b}Ga_{1-b}N layer, and n ≥2;
in the period of nᵢ = 1, the thickness of the AlₐGa₁₋ₐN layer and the Al_{b}Ga_{1-b}N layer are x and y respectively;
in the direction from the quantum well active layer (5) to the electron blocking layer (7), and in the n periods of the AlₐGa₁₋ₐN layer and the Al_{b}Ga_{1-b}N layer, the thickness of the AlₐGa₁₋ₐN layer and the Al_{b}Ga_{1-b}N layer are x ± (nᵢ-1)*t and y ± (nᵢ-1)*t respectively, and 0.1 nm≤t≤10 nm, nᵢ runs from 1 to n;
wherein the AlₐGa₁₋ₐN layer is a single layer structure of a single AlₐGa₁₋ₐN composition, and the Al_{b}Ga_{1-b}N layer is a single layer structure of a single Al_{b}Ga_{1-b}N composition, and 0.4<a<b<1.

2. A deep ultraviolet LED with chirped superlattice final barrier structure, comprising a sapphire substrate (1), an AIN intrinsic layer (2), an N-type AlGaN layer (3), a current spreading layer (4), a quantum well active layer (5), a chirped superlattice final barrier layer (6), an electron blocking layer (7), a P-type AlGaN injection layer (8) and a P-type GaN contact layer (9); wherein the AIN intrinsic layer (2), the N-type AlGaN layer (3), the current spreading layer (4), the quantum well active layer (5), the chirped superlattice final barrier layer (6), the electron blocking layer (7), the P-type AlGaN injection layer (8) and the P-type GaN contact layer (9) have been sequentially deposited on the sapphire substrate (1);
the chirped superlattice final barrier layer (6) is a superlattice structure that is chirped in thickness and is composed of several AlₐGa₁₋ₐN layers and several Al_{b}Ga_{1-b}N layers alternately disposed;
wherein the chirped superlattice final barrier layer (6) is composed of n periods of the AlₐGa₁₋ₐN layer and the Al_{b}Ga_{1-b}N layer, and n ≥2;
in the period of nᵢ = 1, the thickness of the AlₐGa₁₋ₐN layer and the Al_{b}Ga_{1-b}N layer are x and y respectively;
in the direction from the quantum well active layer (5) to the electron blocking layer (7), and in the n periods of the AlₐGa₁₋ₐN layer and the Al_{b}Ga_{1-b}N layer, the thickness of the AlₐGa₁₋ₐN layer and the Al_{b}Ga_{1-b}N layer are x ± (nᵢ-1)*t and y ± (nᵢ-1)*t respectively, and 0.1 nm≤t≤10 nm, nᵢ runs from 1 to n;
wherein the AlₐGa₁₋ₐN layer is a single layer structure with graded composition, and the Al composition ratio a linearly grades from c to d;
the Al_{b}Ga_{1-b}N layer is a single layer structure of a single Al_{b}Ga_{1-b}N composition, wherein 0.4 < c <d < b < 1.

3. A deep ultraviolet LED with chirped superlattice final barrier structure, comprising a sapphire substrate (1), an AIN intrinsic layer (2), an N-type AlGaN layer (3), a current spreading layer (4), a quantum well active layer (5), a chirped superlattice final barrier layer (6), an electron blocking layer (7), a P-type AlGaN injection layer (8) and a P-type GaN contact layer (9);
wherein the AIN intrinsic layer (2), the N-type AlGaN layer (3), the current spreading layer (4), the quantum well active layer (5), the chirped superlattice final barrier layer (6), the electron blocking layer (7), the P-type AlGaN injection layer (8) and the P-type GaN contact layer (9) have been sequentially deposited on the sapphire substrate (1);
the chirped superlattice final barrier layer (6) is a superlattice structure that is chirped in thickness and is composed of several AlₐGa₁₋ₐN layers and several Al_{b}Ga_{1-b}N layers alternately disposed;
wherein the chirped superlattice final barrier layer (6) is composed of n periods of the AlₐGa₁₋ₐN layer and the Al_{b}Ga_{1-b}N layer, and n ≥2;
in the period of nᵢ = 1, the thickness of the AlₐGa₁₋ₐN layer and the Al_{b}Ga_{1-b}N layer are x and y respectively;
in the direction from the quantum well active layer (5) to the electron blocking layer (7), and in the n periods of the AlₐGa₁₋ₐN layer and the Al_{b}Ga_{1-b}N layer, the thickness of the AlₐGa₁₋ₐN layer and the Al_{b}Ga_{1-b}N layer are x ± (nᵢ-1)*t and y ± (nᵢ-1)*t respectively, and 0.1 nm≤t≤10 nm, nᵢ runs from 1 to n;
wherein the AlₐGa₁₋ₐN layer is a single layer structure of a single AlₐGa₁₋ₐN composition;
the Al_{b}Ga_{1-b}N layer is a single layer structure with graded composition, and the Al composition ratio b linearly grades from e to f, wherein 0.4 < a < f < e < 1.

4. A deep ultraviolet LED with chirped superlattice final barrier structure, comprising a sapphire substrate (1), an AIN intrinsic layer (2), an N-type AlGaN layer (3), a current spreading layer (4), a quantum well active layer (5), a chirped superlattice final barrier layer (6), an electron blocking layer (7), a P-type AlGaN injection layer (8) and a P-type GaN contact layer (9);
wherein the AIN intrinsic layer (2), the N-type AlGaN layer (3), the current spreading layer (4), the quantum well active layer (5), the chirped superlattice final barrier layer (6), the electron blocking layer (7), the P-type AlGaN injection layer (8) and the P-type GaN contact layer (9) have been sequentially deposited on the sapphire substrate (1);
the chirped superlattice final barrier layer (6) is a superlattice structure that is chirped in thickness and is composed of several AlₐGa₁₋ₐN layers and several Al_{b}Ga_{1-b}N layers alternately disposed;
wherein the chirped superlattice final barrier layer (6) is composed of n periods of the AlₐGa₁₋ₐN layer and the Al_{b}Ga_{1-b}N layer, and n ≥2; in the period of nᵢ = 1, the thickness of the AlₐGa₁₋ₐN layer and the Al_{b}Ga_{1-b}N layer are x and y respectively;
in the direction from the quantum well active layer (5) to the electron blocking layer (7), and in the n periods of the AlₐGa₁₋ₐN layer and the Al_{b}Ga_{1-b}N layer, the thickness of the AlₐGa₁₋ₐN layer and the Al_{b}Ga_{1-b}N layer are x ± (nᵢ-1)*t and y ± (nᵢ-1)*t respectively, and 0.1 nm≤t≤10 nm, nᵢ runs from 1 to n;
wherein the AlₐGa₁₋ₐN layer is a single layer structure with graded composition, and the Al composition ratio a linearly grades from g to h;
the Al_{b}Ga_{1-b}N layer is a single layer structure with graded composition, and the Al composition ratio b linearly grades from j to k, wherein 0.4 < g < h < j < k < 1.

5. The deep ultraviolet LED with chirped superlattice final barrier structure according to any of claims 1-4, wherein the dopant used in the P-type AlGaN injection layer (8) and the P-type GaN contact layer (9) is Mg.

6. A preparation method of deep ultraviolet LED with chirped superlattice final barrier structure, using a metal-organic chemical vapor deposition method to prepare the deep ultraviolet LED with chirped superlattice final barrier structure described in any of claims 1-4.

7. The preparation method of deep ultraviolet LED with chirped superlattice final barrier structure according to claim 6, including the following steps:
at 400 - 800 °C, growing a buffer layer on a sapphire substrate (1) and the thickness of the buffer layer is 10 - 50 nm;
raising the temperature to 1200 - 1400°C, and an AIN intrinsic layer (2) is grown on the buffer layer, the total thickness of the AIN intrinsic layer (2) is 500 - 4000 nm;
cooling to 800 - 1200 °C, and an N-type AlGaN layer (3) is grown on the AIN intrinsic layer (2), wherein the Al mass percentage is 20 - 90 %, and the thickness is 500 - 4000 nm;
cooling to 700 - 1100 °C, and a current spreading layer (4) and a quantum well active layer (5) are sequentially grown on the N-type AlGaN layer (3), wherein the thickness of the barrier in the quantum well active layer (5) is 5 ~30 nm and the mass percentage of Al composition in the barrier is 20 - 100 %; the thickness of the potential well is 0.1 - 5 nm and the mass percentage of Al composition in the potential well is 5 - 80 %;
at 700 - 1100 °C, growing a chirped superlattice final barrier layer (6) on the quantum well active layer (5); the chirped superlattice final barrier layer (6) is a superlattice structure that is chirped in thickness and is composed of several AlₐGa₁₋ₐN layers and several Al_{b}Ga_{1-b}N layers alternately, and a<b, wherein the thickness of the Al_{b}Ga_{1-b}N layer is 0.1 - 5 nm and 0.2<b<1, and the thickness of the AlₐGa₁₋ₐN layer is 0.1 - 5 nm and 0.05 < a < 0.8;
at 700 - 1100 °C, growing an electron blocking layer (7) on the chirped superlattice final barrier layer (6) with a thickness of 5 - 50 nm and 30 - 100 mass % of Al;
at 700 - 1100 °C, growing a P-type AlGaN injection layer (8) on the electron blocking layer (7) with 5 - 100 mass % of Al and a thickness of 1 - 50 nm, and Mg is used as the P-type dopant;
at 400 - 900 °C, a P-type GaN contact layer (9) is grown on the P-type AlGaN injection layer (8) with a thickness of 1 - 20 nm, and Mg is used as the p-type dopant.

## Patentansprüche

1. Tief ultraviolette LED mit einer gechirpten Übergitter-Endbarrierestruktur, die ein Saphir-Substrat (1), eine intrinsische AlN-Schicht (2), eine AlGaN-Schicht (3) vom N-Typ, eine Stromverteilungsschicht (4), eine aktive Quantenwellschicht (5), eine gechirpte Übergitter-Endbarriereschicht (6), eine Elektronenblockierschicht (7), eine AlGaN-Injektionsschicht (8) vom P-Typ und eine GaN-Kontaktschicht (9) vom P-Typ umfasst;
wobei die intrinsische AlN-Schicht (2), die AlGaN-Schicht (3) vom N-Typ, die Stromverteilungsschicht (4), die aktive Quantenwellschicht (5), die gechirpte Übergitter-Endbarriereschicht (6), die Elektronenblockierschicht (7), die AlGaN-Injektionsschicht (8) vom P-Typ und die GaN-Kontaktschicht (9) vom P-Typ nacheinander auf dem Saphir-Substrat (1) abgeschieden wurden;
wobei die gechirpte Übergitter-Endbarriereschicht (6) eine Übergitterstruktur ist, die in der Dicke gechirpt ist und aus mehreren AlₐGa₁₋ₐN-Schichten und mehreren Al_{b}Ga_{1-b}N-Schichten besteht, die abwechselnd angeordnet sind;
wobei die gechirpte Übergitter-Endbarriereschicht (6) aus n Perioden der AlₐGa₁₋ₐN-Schichte und der Al_{b}Ga_{1-b}N-Schicht zusammengesetzt ist und n≥2;
wobei in der Periode von ni = 1 die Dicke der AlₐGa₁₋ₐN-Schicht und der Al_{b}Ga_{1-b}N-Schicht jeweils x bzw. y beträgt;
wobei in der Richtung von der aktiven Quantenwellschicht (5) zur Elektronenblockierschicht (7) und in den n Perioden der AlₐGa₁₋ₐN-Schicht und der Al_{b}Ga_{1-b}N-Schicht die Dicken der AlₐGa₁₋ₐN-Schicht und der Al_{b}Ga_{1-b}N-Schicht x ± (ni-1)*t bzw. y ± (ni-1)*t beträgen, wobei 0,1 nm≤t≤10 nm und nᵢ von 1 bis n läuft;
wobei die AlₐGa₁₋ₐN-Schicht eine Einzelschichtstruktur aus einer einzelnen AlₐGa₁₋ₐN-Zusammensetzung ist und die Al_{b}Ga_{1-b}N-Schicht eine Einzelschichtstruktur aus einer einzelnen Al_{b}Ga_{1-b}N-Zusammensetzung ist und 0,4 < a < b < 1 ist.

2. Tief ultraviolette LED mit einer gechirpten Übergitter-Endbarrierestruktur, die ein Saphir-Substrat (1), eine intrinsische AlN-Schicht (2), eine AlGaN-Schicht (3) vom N-Typ, eine Stromverteilungsschicht (4), eine aktive Quantenwellschicht (5), eine gechirpte Übergitter-Endbarriereschicht (6), eine Elektronenblockierschicht (7), eine AlGaN-Injektionsschicht (8) vom P-Typ und eine GaN-Kontaktschicht (9) vom P-Typ umfasst;
wobei die intrinsische AlN-Schicht (2), die AlGaN-Schicht (3) vom N-Typ, die Stromverteilungsschicht (4), die aktive Quantenwellschicht (5), die gechirpte Übergitter-Endbarriereschicht (6), die Elektronenblockierschicht (7), die AlGaN-Injektionsschicht (8) vom P-Typ und die GaN-Kontaktschicht (9) vom P-Typ nacheinander auf dem Saphir-Substrat (1) abgeschieden wurden;
wobei die gechirpte Übergitter-Endbarriereschicht (6) eine Übergitterstruktur ist, die in der Dicke gechirpt ist und aus mehreren AlₐGa₁₋ₐN-Schichten und mehreren Al_{b}Ga_{1-b}N-Schichten besteht, die abwechselnd angeordnet sind;
wobei die gechirpte Übergitter-Endbarriereschicht (6) aus n Perioden der AlₐGa₁₋ₐN-Schichte und der Al_{b}Ga_{1-b}N-Schicht zusammengesetzt ist und n≥2;
wobei in der Periode von ni = 1 die Dicke der AlₐGa₁₋ₐN-Schicht und der Al_{b}Ga_{1-b}N-Schicht jeweils x bzw. y beträgt;
wobei in der Richtung von der aktiven Quantenwellschicht (5) zur Elektronenblockierschicht (7) und in den n Perioden der AlₐGa₁₋ₐN-Schicht und der AlbGa1-bN-Schicht die Dicken der AlₐGa₁₋ₐN-Schicht und der Al_{b}Ga_{1-b}N-Schicht x ± (ni-1)*t bzw. y ± (ni-1)*t beträgen, wobei 0,1 nm≤t≤10 nm und nᵢ von 1 bis n läuft;
wobei die AlₐGa₁₋ₐN-Schicht eine Einzelschichtstruktur mit abgestufter Zusammensetzung ist und das Al-Zusammensetzungsverhältnis a linear von c bis d abgestuft ist; und
wobei die Al_{b}Ga_{1-b}N-Schicht eine Einzelschichtstruktur aus einer einzelnen Al_{b}Ga_{1-b}N-Zusammensetzung ist, wobei 0,4<c<d<b<1.

3. Tief ultraviolette LED mit einer gechirpten Übergitter-Endbarrierestruktur, die ein Saphir-Substrat (1), eine intrinsische AlN-Schicht (2), eine AlGaN-Schicht (3) vom N-Typ, eine Stromverteilungsschicht (4), eine aktive Quantenwellschicht (5), eine gechirpte Übergitter-Endbarriereschicht (6), eine Elektronenblockierschicht (7), eine AlGaN-Injektionsschicht (8) vom P-Typ und eine GaN-Kontaktschicht (9) vom P-Typ umfasst;
wobei die intrinsische AlN-Schicht (2), die AlGaN-Schicht (3) vom N-Typ, die Stromverteilungsschicht (4), die aktive Quantenwellschicht (5), die gechirpte Übergitter-Endbarriereschicht (6), die Elektronenblockierschicht (7), die AlGaN-Injektionsschicht (8) vom P-Typ und die GaN-Kontaktschicht (9) vom P-Typ nacheinander auf dem Saphir-Substrat (1) abgeschieden wurden;
wobei die gechirpte Übergitter-Endbarriereschicht (6) eine Übergitterstruktur ist, die in der Dicke gechirpt ist und aus mehreren AlₐGa₁₋ₐN-Schichten und mehreren Al_{b}Ga_{1-b}N-Schichten besteht, die abwechselnd angeordnet sind;
wobei die gechirpte Übergitter-Endbarriereschicht (6) aus n Perioden der AlaGa1-aN-Schichte und der AlbGa1-bN-Schicht zusammengesetzt ist und n≥2;
wobei in der Periode von ni = 1 die Dicke der AlaGa1-aN-Schicht und der Al_{b}Ga_{1-b}N-Schicht jeweils x bzw. y beträgt;
wobei in der Richtung von der aktiven Quantenwellschicht (5) zur Elektronenblockierschicht (7) und in den n Perioden der AlₐGa₁₋ₐN-Schicht und der Al_{b}Ga_{1-b}N-Schicht die Dicken der AlₐGa₁₋ₐN-Schicht und der Al_{b}Ga_{1-b}N-Schicht x ± (ni-1)*t bzw. y ± (ni-1)*t beträgen, wobei 0,1 nm≤t≤10 nm und nᵢ von 1 bis n läuft;
wobei die AlₐGa₁₋ₐN-Schicht eine Einzelschichtstruktur aus einer einzelnen AlₐGa₁₋ₐN-Zusammensetzung ist;
wobei die Al_{b}Ga_{1-b}N-Schicht eine Einzelschichtstruktur mit abgestufter Zusammensetzung ist und das Al-Zusammensetzungsverhältnis b linear von e bis f abstuft, wobei 0,4<a<f<e<1.

4. Tief ultraviolette LED mit einer gechirpten Übergitter-Endbarrierestruktur, die ein Saphir-Substrat (1), eine intrinsische AlN-Schicht (2), eine AlGaN-Schicht (3) vom N-Typ, eine Stromverteilungsschicht (4), eine aktive Quantenwellschicht (5), eine gechirpte Übergitter-Endbarriereschicht (6), eine Elektronenblockierschicht (7), eine AlGaN-Injektionsschicht (8) vom P-Typ und eine GaN-Kontaktschicht (9) vom P-Typ umfasst;
wobei die intrinsische AlN-Schicht (2), die AlGaN-Schicht (3) vom N-Typ, die Stromverteilungsschicht (4), die aktive Quantenwellschicht (5), die gechirpte Übergitter-Endbarriereschicht (6), die Elektronenblockierschicht (7), die AlGaN-Injektionsschicht (8) vom P-Typ und die GaN-Kontaktschicht (9) vom P-Typ nacheinander auf dem Saphir-Substrat (1) abgeschieden wurden;
wobei die gechirpte Übergitter-Endbarriereschicht (6) eine Übergitterstruktur ist, die in der Dicke gechirpt ist und aus mehreren AlₐGa₁₋ₐN-Schichten und mehreren Al_{b}Ga_{1-b}N-Schichten besteht, die abwechselnd angeordnet sind;
wobei die gechirpte Übergitter-Endbarriereschicht (6) aus n Perioden der AlₐGa₁₋ₐN-Schichte und der Al_{b}Ga_{1-b}N-Schicht zusammengesetzt ist und n≥2;
wobei in der Periode von ni = 1 die Dicke der AlₐGa₁₋ₐN-Schicht und der Al_{b}Ga_{1-b}N-Schicht jeweils x bzw. y beträgt;
wobei in der Richtung von der aktiven Quantenwellschicht (5) zur Elektronenblockierschicht (7) und in den n Perioden der AlₐGa₁₋ₐN-Schicht und der Al_{b}Ga_{1-b}N-Schicht die Dicken der AlₐGa₁₋ₐN-Schicht und der Al_{b}Ga_{1-b}N-Schicht x ± (ni-1)*t bzw. y ± (ni-1)*t beträgen, wobei 0,1 nm≤t≤10 nm und nᵢ von 1 bis n läuft;
wobei die AlₐGa₁₋ₐN-Schicht eine Einzelschichtstruktur mit abgestufter Zusammensetzung ist und das Al-Zusammensetzungsverhältnis a linear von g bis h abgestuft ist; und
die Al_{b}Ga_{1-b}N-Schicht ist eine Einzelschichtstruktur mit abgestufter Zusammensetzung, und das Al-Zusammensetzungsverhältnis b linear von j bis k ist abgestuft, wobei 0,4< g<h<j<k<1.

5. Tief ultraviolette LED mit einer gechirpten Übergitter-Endbarrierestruktur nach einem der Ansprüche 1-4, wobei das in der AlGaN-Injektionsschicht (8) vom P-Typ und der GaN-Kontaktschicht (9) vom P-Typ verwendete Dotiermittel Mg ist.

6. Verfahren zur Herstellung einer tief ultravioletten LED mit gechirpter Übergitter-Endbarrierestruktur unter Verwendung eines metallorganischen chemischen Gasphasenabscheidungsverfahrens zur Herstellung der tief ultravioletten LED mit gechirpter Übergitter-Endbarrierestruktur, die in einem der Ansprüche 1-4 beschrieben ist.

7. Verfahren zur Herstellung einer tief ultravioletten LED mit gechirpter Übergitter-Endbarrierenstruktur nach Anspruch 6, das die folgenden Schritte umfasst:
Aufwachsen einer Pufferschicht auf einem Saphir-Substrat (1) bei 400 - 800 °C, wobei die Dicke der Pufferschicht 10 - 50 nm beträgt;
Erhöhen der Temperatur auf 1200 bis 1400 °C, und Aufwachsen einer intrinsischen AlN-Schicht (2) auf der Pufferschicht, wobei die Gesamtdicke der intrinsischen AlN-Schicht (2) 500 bis 4000 nm beträgt;
Abkühlen der Temperatur auf 800 - 1200 °C und Aufwachsen einer AlGaN-Schicht (3) vom N-Typ auf der intrinsischen AlN-Schicht (2), wobei der Al-Massenprozentsatz 20 - 90 % beträgt und die Dicke 500 - 4000 nm beträgt;
Abkühlen der Temperatur auf 700 - 1100 °C, wobei eine Stromverteilungsschicht (4) und eine aktive Quantenwellschicht (5) nacheinander auf der AlGaN-Schicht (3) vom N-Typ aufgewachsen werden, wobei die Dicke der Barriere in der aktiven Quantenwellschicht (5) 5 - 30 nm beträgt und der Massenprozentsatz der Al-Zusammensetzung in der Barriere 20 - 100 % beträgt; wobei die Dicke der Potentialwell 0,1 - 5 nm beträgt und der Massenprozentsatz der Al-Zusammensetzung in der Potentialwell 5 - 80 % beträgt;
bei 700 - 1100 °C, Aufwachsen einer gechirpten Übergitter-Endbarriereschicht (6) auf der aktiven Quantenwellschicht (5); wobei die gechirpte Übergitter-Endbarriereschicht (6) eine Übergitterstruktur ist, die in der Dicke gechirpt ist und aus mehreren AlₐGa₁₋ₐN-Schichten und mehreren Al_{b}Ga_{1-b}N-Schichten abwechselnd zusammengesetzt ist, und a<b, wobei die Dicke der Al_{b}Ga_{1-b}N-Schicht 0. 1 - 5 nm und 0,2<b<1 beträgt, und die Dicke der AlₐGa₁₋ₐN-Schicht 0,1 - 5 nm und 0,05<a<0,8 beträgt;
bei 700 - 1100 °C, Aufwachsen einer Elektronenblockierschicht (7) auf der gechirpten Übergitter-Endbarriereschicht (6) mit einer Dicke von 5 - 50 nm und 30 - 100 Massen-% Al;
bei 700 - 1100 °C, Aufwachsen einer AlGaN-Injektionsschicht (8) vom P-Typ auf der Elektronenblockierschicht (7) mit 5 - 100 Massen-% Al und einer Dicke von 1 - 50 nm, wobei Mg als P-Typ-Dotiermittel verwendet wird, und
bei 400 - 900 °C, Aufwachsen einer GaN-Kontaktschicht (9) vom P-Typ auf der AlGaN-Injektionsschicht (8) vom P-Typ mit einer Dicke von 1 - 20 nm, wobei Mg als P-Typ-Dotiermittel verwendet wird.

## Revendications

1. LED ultraviolette profonde avec une structure de ultime barrière de réseau cristallin de gazouillis, comprenant un substrat saphir (1), une couche intrinsèque d'AlN (2), une couche d'AlGaN de type N (3), une couche à propagation de courant (4), une couche active de puits quantique (5), une couche de ultime barrière de réseau cristallin de gazouillis (6), une couche de blocage d'électrons (7), une couche d'injection d'AlGaN de type P (8) et une couche de contact d' GaN de type P (9) ;
**caractérisé en ce que** ladite couche intrinsèque d'AlN (2), ladite couche d'AlGaN de type N (3), ladite couche à propagation de courant (4), ladite couche active de puits quantique (5), ladite couche de ultime barrière de réseau cristallin de gazouillis (6), ladite couche de blocage d'électrons (7), ladite couche d'injection d'AlGaN de type P (8) et ladite couche de contact d' GaN de type P (9) sont déposées séquentiellement sur ledit substrat de saphir (1) ;
ladite couche de ultime barrière de réseau cristallin de gazouillis (6) est une structure de réseau cristallin qui fait gazouillis d' épaisseur et est composée de plusieurs couches d'AlₐGa₁₋ₐN et de plusieurs couches d'Al_{b}Ga_{1-b}N en alternance;
ladite couche de ultime barrière de réseau cristallin de gazouillis (6) est form en passant par n cycles de dépositions de la couche d'AlₐGa₁₋ₐN et de la couche d'Al_{b}Ga_{1-b}N, et n≥2 ;
dans le cycle de n;=1, la couche d'AlₐGa₁₋ₐN et de la couche d'Al_{b}Ga_{1-b}N font respectivement x et y d' épaisseurs ;
dans la direction de ladite couche active du puits quantique (5) à ladite couche de blocage d'électrons (7), et dans les n cycles de dépositions de la couche d'AlₐGa₁₋ₐN et de la couche d'Al_{b}Ga_{1-b}N, la couche d'AlaGa1-aN et de la couche d'AlbGa1-bN font respectivement x ± (nᵢ-1)*t et y ± (nᵢ-1)*t d'épaisseur, et 0.1 nm≤t≤10 nm, nᵢ varie de 1 à n;
la couche d'AlₐGa₁₋ₐN est une structure monocouche d'une seule composition AlₐGa₁₋ₐN, et la couche d' Al_{b}Ga_{1-b}N est une structure monocouche d'une seule composition Al_{b}Ga_{1-b}N, et 0.4<a<b<1.

2. LED ultraviolette profonde avec une structure de ultime barrière de réseau cristallin de gazouillis, comprenant un substrat saphir (1), une couche intrinsèque d'AlN (2), une couche d'AlGaN de type N (3), une couche à propagation de courant (4), une couche active de puits quantique (5), une couche de ultime barrière de réseau cristallin de gazouillis (6), une couche de blocage d'électrons (7), une couche d'injection d'AlGaN de type P (8) et une couche de contact d' GaN de type P (9) ;
**caractérisé en ce que** ladite couche intrinsèque d'AlN (2), ladite couche d'AlGaN de type N (3), ladite couche à propagation de courant (4), ladite couche active de puits quantique (5), ladite couche de ultime barrière de réseau cristallin de gazouillis (6), ladite couche de blocage d'électrons (7), ladite couche d'injection d'AlGaN de type P (8) et ladite couche de contact d' GaN de type P (9) sont déposées séquentiellement sur ledit substrat de saphir (1) ;
ladite couche de ultime barrière de réseau cristallin de gazouillis (6) est une structure de réseau cristallin qui fait gazouillis d' épaisseur et est composée de plusieurs couches d'AlₐGa₁₋ₐN et de plusieurs couches d'Al_{b}Ga_{1-b}N en alternance;
ladite couche de ultime barrière de réseau cristallin de gazouillis (6) est form en passant par n cycles de dépositions de la couche d'AlₐGa₁₋ₐN et de la couche d'Al_{b}Ga_{1-b}N, et n≥2 ;
dans le cycle de nᵢ=2, la couche d'AlₐGa₁₋ₐN et de la couche d'Al_{b}Ga_{1-b}N font respectivement x et y d' épaisseurs ;
dans la direction de ladite couche active du puits quantique (5) à ladite couche de blocage d'électrons (7), et dans les n cycles de dépositions de la couche d'AlₐGa₁₋ₐN et de la couche d'Al_{b}Ga_{1-b}N, la couche d'AlaGa1-aN et de la couche d'AlbGa1-bN font respectivement x ± (nᵢ-1)*t et y ± (nᵢ-1)*t d'épaisseur, et 0.1 nm≤t≤10 nm, nᵢ varie de 1 à n;
la couche d'AlₐGa₁₋ₐN est une structure monocouche composite à gradient, et le ratio a de Al composition représente un gradient linéaire de c à d; et la couche d' Al_{b}Ga_{1-b}N est une structure monocouche d'une seule composition Al_{b}Ga_{1-b}N, et 0.4<c<d<b<1.

3. LED ultraviolette profonde avec une structure de ultime barrière de réseau cristallin de gazouillis, comprenant un substrat saphir (1), une couche intrinsèque d'AlN (2), une couche d'AlGaN de type N (3), une couche à propagation de courant (4), une couche active de puits quantique (5), une couche de ultime barrière de réseau cristallin de gazouillis (6), une couche de blocage d'électrons (7), une couche d'injection d'AlGaN de type P (8) et une couche de contact d' GaN de type P (9) ;
**caractérisé en ce que** ladite couche intrinsèque d'AlN (2), ladite couche d'AlGaN de type N (3), ladite couche à propagation de courant (4), ladite couche active de puits quantique (5), ladite couche de ultime barrière de réseau cristallin de gazouillis (6), ladite couche de blocage d'électrons (7), ladite couche d'injection d'AlGaN de type P (8) et ladite couche de contact d' GaN de type P (9) sont déposées séquentiellement sur ledit substrat de saphir (1) ;
ladite couche de ultime barrière de réseau cristallin de gazouillis (6) est une structure de réseau cristallin qui fait gazouillis d' épaisseur et est composée de plusieurs couches d'AlₐGa₁₋ₐN et de plusieurs couches d'Al_{b}Ga_{1-b}N en alternance;
ladite couche de ultime barrière de réseau cristallin de gazouillis (6) est form en passant par n cycles de dépositions de la couche d'AlₐGa₁₋ₐN et de la couche d'Al_{b}Ga_{1-b}N, et n≥2 ;
dans le cycle de nᵢ=2, la couche d'AlₐGa₁₋ₐN et de la couche d'Al_{b}Ga_{1-b}N font respectivement x et y d' épaisseurs ;
dans la direction de ladite couche active du puits quantique (5) à ladite couche de blocage d'électrons (7), et dans les n cycles de dépositions de la couche d'AlₐGa₁₋ₐN et de la couche d'Al_{b}Ga_{1-b}N, la couche d'AlaGa1-aN et de la couche d'AlbGa1-bN font respectivement x ± (nᵢ-1)*t et y ± (nᵢ-1)*t d'épaisseur, et 0.1 nm≤t≤10 nm, nᵢ varie de 1 à n;
la couche d' AlₐGa₁₋ₐN est une structure monocouche d'une seule composition AlₐGa₁₋ₐN, et la couche d' Al_{b}Ga_{1-b}N est une structure monocouche composite à gradient, et le ratio b de Al composition représente un gradient linéaire de e à f; et 0,4 < a < f < e < 1.

4. LED ultraviolette profonde avec une structure de ultime barrière de réseau cristallin de gazouillis, comprenant un substrat saphir (1), une couche intrinsèque d'AlN (2), une couche d'AlGaN de type N (3), une couche à propagation de courant (4), une couche active de puits quantique (5), une couche de ultime barrière de réseau cristallin de gazouillis (6), une couche de blocage d'électrons (7), une couche d'injection d'AlGaN de type P (8) et une couche de contact d' GaN de type P (9) ;
**caractérisé en ce que** ladite couche intrinsèque d'AlN (2), ladite couche d'AlGaN de type N (3), ladite couche à propagation de courant (4), ladite couche active de puits quantique (5), ladite couche de ultime barrière de réseau cristallin de gazouillis (6), ladite couche de blocage d'électrons (7), ladite couche d'injection d'AlGaN de type P (8) et ladite couche de contact d' GaN de type P (9) sont déposées séquentiellement sur ledit substrat de saphir (1) ;
ladite couche de ultime barrière de réseau cristallin de gazouillis (6) est une structure de réseau cristallin qui fait gazouillis d' épaisseur et est composée de plusieurs couches d'AlₐGa₁₋ₐN et de plusieurs couches d'Al_{b}Ga_{1-b}N en alternance;
ladite couche de ultime barrière de réseau cristallin de gazouillis (6) est form en passant par n cycles de dépositions de la couche d'AlₐGa₁₋ₐN et de la couche d'Al_{b}Ga_{1-b}N, et n≥2 ;
dans le cycle de nᵢ=2, la couche d'AlₐGa₁₋ₐN et de la couche d'Al_{b}Ga_{1-b}N font respectivement x et y d' épaisseurs ;
dans la direction de ladite couche active du puits quantique (5) à ladite couche de blocage d'électrons (7), et dans les n cycles de dépositions de la couche d'AlₐGa₁₋ₐN et de la couche d'Al_{b}Ga_{1-b}N, la couche d'AlaGa1-aN et de la couche d'AlbGa1-bN font respectivement x ± (nᵢ-1)*t et y ± (nᵢ-1)*t d'épaisseur, et 0.1 nm≤t≤10 nm, nᵢ varie de 1 à n;
la couche d'AlₐGa₁₋ₐN est une structure monocouche composite à gradient, et le ratio a de Al composition représente un gradient linéaire de g à h;
la couche d' Al_{b}Ga_{1-b}N est une structure monocouche composite à gradient, et le ratio b de Al composition représente un gradient linéaire de j à k; et 0.4<g<h<j <k< 1.

5. LED ultraviolette profonde avec une structure de ultime barrière de réseau cristallin de gazouillis selon l'une des revendications 1 à 4, **caractérisée en ce que** un agent dopant utilisé dans ladite couche d'injection d'AlGaN de type P (8) et ladite couche de contact d' GaN de type P (9) est Mg.

6. Procédé de préparation de LED ultraviolette profonde avec une structure de ultime barrière de réseau cristallin de gazouillis, adoptant un dépôt chimique organométallique en phase vapeur pour préparer la LED ultraviolette profonde avec une structure de ultime barrière de réseau cristallin de gazouillis décrite dasn l'une des revendications 1 à 4

7. Procédé de préparation de LED ultraviolette profonde avec une structure de ultime barrière de réseau cristallin de gazouillis selon la revendication 6, **caractérisé en ce que** le procédé comprend les étapes de :
former une couche tampon sur un substrat de saphir (1) à 400~800 °C en sorte que la couche tampon fait 10-50 nm d'épaisseur,
élever la température à 1200-1400 °C et former une couche intrinsèque d'AIN (2) sur la couche tampon en sorte que la couche intrinsèque de'AlN (2) fait 500-4000 nm d'épaisseur au total;
se rafraîchir à 800-1200 °C et former une couche d'AlGaN de type N (3) sur la couche intrinsèque d'AIN (2), dans laquelle le pourcentage pondéral de Al atteint 20-90 % et la couche d'AlGaN de type N (3) fait 500-4000 nm d'épaisseur,
se rafraîchir à 700-1100 °C et former une couche à propagation de courant (4) et une couche active de puits quantique (5) séquentiellement sur la couche d'AlGaN de type N (3), dans lesquelles la barrière dans la couche active de puits quantique (5) fait 5-30 nm d'épaisseur et le pourcentage pondéral de Al composition dans la barrière atteint 20-100 %; le puits de potentiel fait 0. 1~5nm d'épaisseur et le pourcentage pondéral de Al composition dans le puits de potentiel atteint 5-80 %;
former une couche de ultime barrière de réseau cristallin de gazouillis (6) sur la couche active de puits quantique (5) à 700-1100 °C en sorte que la couche de ultime barrière de réseau cristallin de gazouillis (6) est une structure de réseau cristallin qui fait gazouillis d' épaisseur et est composée de plusieurs couches d'AlₐGa₁₋ₐN et de plusieurs couches d'Al_{b}Ga_{1-b}N en alternance, et a<b, dans lesquelles la couche d'AlₐGa₁₋ₐN fait 0.1-5 nm d' épaisseur et 0.2<b<1, et la couche d'Al_{b}Ga_{1-b}N fait 0.1-5 nm d' épaisseur et 0,05<a<0,8;
former une couche de blocage d'électrons (7) sur la couche de ultime barrière de réseau cristallin de gazouillis (6) à 700-1100 °C en sorte que le pourcentage pondéral de Al atteint 30-100 % et la couche de blocage d'électrons (7) fait 5-50 nm d'épaisseur,
former une couche d'injection d'AlGaN de type P (8) sur la couche de blocage d'électrons (7) à 700-1100 °C en sorte que le pourcentage pondéral de Al atteint 5-100 % et la couche d'injection d'AlGaN de type P (8) fait 1-50 nm d'épaisseur, dans laquelle Mg est utilisé comme un agent dopant de type P ;
former une couche de contact d' GaN de type P (9) sur la couche d'injection d'AlGaN de type P (8) à 400-900 °C en sorte que la couche de contact d' GaN de type P (9) fait 1-20 nm d'épaisseur, dans laquelle Mg est utilisé comme un agent dopant de type P.
